# EUROPEAN PATENT APPLICATION

(11) **EP 1 133 014 A2**
(43) Date of publication of application: **12.09.2001**
(21) Application number: 01106281.7
(22) Date of filing: 07.03.2001
(51) Int. Cl.: H01R 13/22

(54) **Electrical connector**

(30) Priority: 06.03.2000 JP 2000060127
(71) Applicant: HIROSE ELECTRIC CO., LTD., Shinagawa-ku Tokyo (JP)
(72) Inventor: Sakata, Tsuyoshi, Shinagawa-ku, Tokyo (JP); Nagawatari, Takashi, Shinagawa-ku, Tokyo (JP); Tanaka, Masahiro, Shinagawa-ku, Tokyo (JP)
(74) Representative: Pätzold, Herbert, Dr.-Ing.

(57) **Abstract**

An electrical connector is supported by a light conductive plate (2) that is provided between a circuit board (1) and a liquid crystal display (LCD 3) to electrically connect the circuit board (1) and the LCD (3). It comprises a plurality of contact elements (13) that are made of an electrically conductive elastomer and a holder section (10) molded together with the contact elements (13). The cylindrical contact elements (13) have opposite ends projecting from the holder section (10) for spring contact with corresponding circuit traces of the circuit board and the LCD.

## Description

The present invention relates to electrical connectors and, particularly, to an electrical connector with a contact element made of an electrically conductive elastomer.

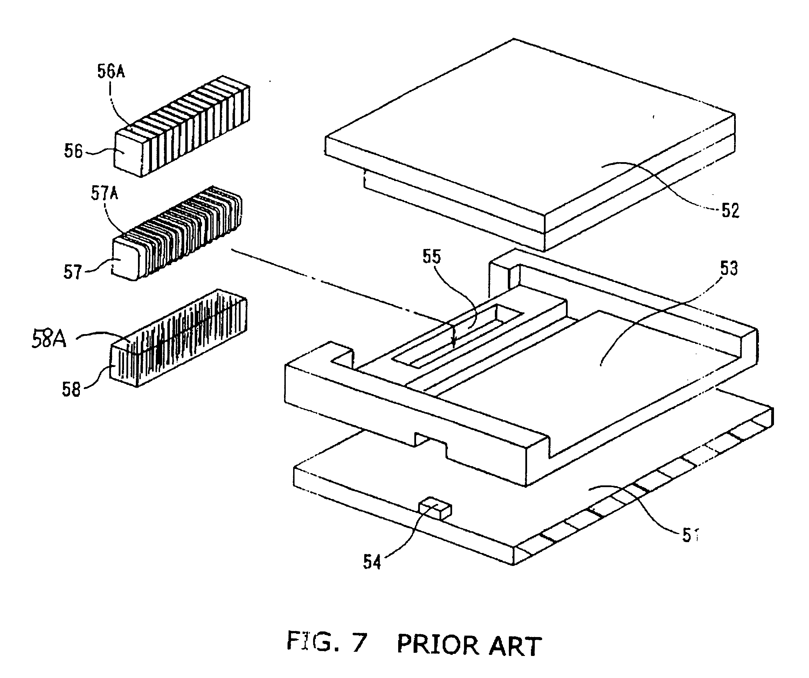

It is well known to provide a light conductive plate between a circuit board and a liquid crystal display (LCD) to conduct light from the light emitting diode (LED) on the circuit hoard to the LCD. The circuit board and the LCD are electrically connected by an intermediate connector provided in the window of the light conductive plate. An example thereof is shown in Fig. 7. A circuit board 51 and an LCD 52 are assembled via a light conductive plate 53. An LED 54 is mounted on the circuit board 51. A rectangular window 55 is provided along a side of the light conductive plate 53 to receive an intermediate connector 56, 57, or 58.

The intermediate connector 56 is composed of a plurality of electrically conductive plates 56A spaced at regular intervals and integrally molded with a resin. The intermediate connector 57 is composed of a plurality of electrically conductive wires 57A provided around a resin rod. The intermediate connector 58 is composed of a plurality of electrically conductive needles 58A provided at random in a rectangular resin body such that the upper and lower ends thereof are flush with the upper and lower faces of the resin body.

In use, when the circuit board 51 and the LCD 52 are assembled with the light conductive plate 53, the electrically conductive plates 56A, wires 57A, or needles 58A of the intermediate connector 56, 57, or 50 electrically connect. corresponding circuit traces of the circuit board 51 and the LCD 52.

In the above intermediate connectors, the positions of contact elements or the electrically conductive plates 56A, wires 57A, or needles 58A are determined by the shape of the resin body or deformation thereof. The resin body has an elongated form and the height varies along the length thereof owing to manufacturing errors. The circuit board and/or LCD also is deformed, causing a dimensional error. That is, the error or deformation of the resin body at one of the electrically conductive plates 56 has an influence on the contact conditions of the other conductive plates 56. Also, it makes it difficult for the intermediate connector to follow the deformation of the circuit board 51 and/or LCD 52, failing to provide good contact.

Accordingly, it is an object of the invention to provide an electrical connector with contact elements capable of making contact independently.

This object is achieved by the invention as claimed in claim 1.

It is another object of the invention to provide an electrical connector capable of eliminating insertion of the light conductive plate, thus simplifying the assembly.

This object is achieved by the invention as claimed in claim 7.

Embodiments of the invention will now he described by way of example with reference to the accompanying drawings, in which
Fig. 1 is an exploded perspective view of an electrical connector before assembled according to the first embodiment of the invention;
Fig. 2 is a sectional view of the electrical connector after assembled;
Fig. 3 is a perspective, sectional view of an electrical connector according to the first modification made Lo the first embodiment;
Fig. 4 is a perspective, sectional view of an electrical connector according to the second modification made Lo the first embodiment;
Fig. 5 is a sectional view of an electrical connector according to the third modification made to the first embodiment;
Fig. 6 is a sectional view of an electrical connector according to the second embodiment of the invention; and
Fig. 7 is an exploded perspective view of a conventional electrical connector before assembled.

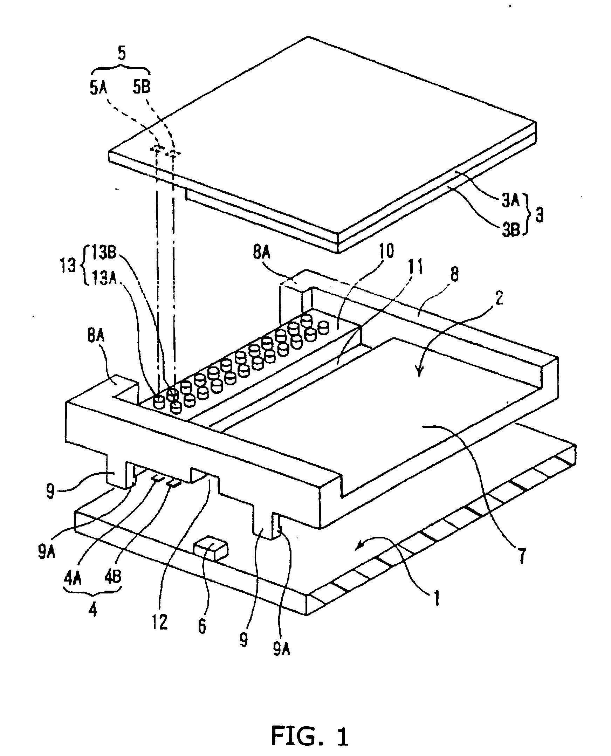

In Fig. 1, a display or LCD 3 is placed on a circuit board 1 via a light conductive plate 2 for electrical connection. A plurality of circuit traces 4 (4A, 4B,...) and 5 (5A, 5B, ...) are provided at corresponding positions on the upper face of the circuit board 1 and the lower face of the LCD 3, respectively. An LED 6 is mounted on the circuit board 1 and supplied with power from a driving circuit (not shown) on the circuit board 1 for emitting light. The LCD is composed of upper and lower panels 3A and 3B for holding the required circuit between them. The upper panel 3A extends forwardly (to the left in the figure) more than the lower panel 3B and the circuit traces 5 are provided on the lower face of the extended upper panel 3A. Such an LCD 3 is well known and the detailed description is omitted.

The light conductive plate 2 is made of a light conductive material so as to provide a transparent flat section 7 for dispersing and transmitting light, a pair of frame sections 8, two pairs of leg portions 9 extending downwardly from the frame sections 8, and a holder section 10 provided at the front edge of the light conductive plate 2. The transparent section 7 of the light conductive plate 2 is opposed to the lower panel 3B in an area substantially equal to that of the lower panel 3B. The distance between the frame sections 8 is determined so that the lower panel 3B is fitted in a space between them. A front-end portion 8A extends inwardly from each of the front encs of frame sections 8 to determine the position of the front edge of the LCD 3 (upper panel 3A). The holder section 10 is made of the same material as that of the light conductive plate 2 and connected to the frame sections 8 but separated from the transparent section 7 by an elongated window 11. A recess 12 is provided in one of the frame sections 8 at a position corresponding to that of the LED 6 for accommodation thereof.

A plurality of contact elements 13 (13A, 13B, ...) are supported by the holder section 10 at such positions as to connect the circuit traces 4 of the circuit board 1 and the circuit traces 5 of the LCD 3 When the circuit board 1 and the LCD 3 are assembled via the light conductive plate 2. The contact elements 13 and the holder section 10 constitute an electrical connector. Each contact element 13 is made of an electrically conductive elastomer in the form of a column with opposite ends projecting from the holder section 10 so that the respective contact elements 13 undergo elastic deformation independently between the circuit board 1 and the LCD 3. The electrically conductive elastomer is made of a mixture of an elastic polymer material and an electrically conductive powder or flakes.

Examples of the elastic polymer material include silicone rubber, polybutagien rubber, natural rubber, polyisopulene, styrene-butadiene copolymer, acrylonitrile-butadiene copolymer, ethylene-propylene copolymer, urethane rubber, polyester rubber, chloroprene rubber, epichlorohydrin rubber, and soft liquid epoxy rubber.

Examples of the electrically conductive material include at least one of gold, silver, nickel, copper, tin, aluminum, palladium, and carbon in the form of at least one of powder, granules, grains, flakes, and indeterminate form. The preferred material and form are silver and flakes. Tt is preferred that the surfaces of silver powder particles are treated with an organic silicon compound.

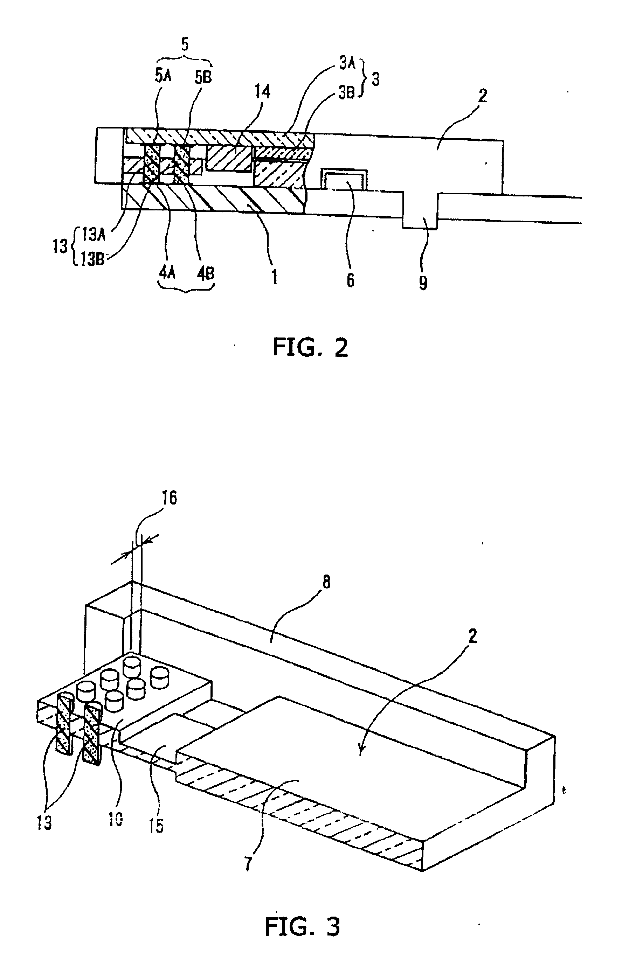

In Fig. 2, to assemble the connector, the light conductive plate 2 is attached to the circuit board 1 such that the leg portions 9 with claws 9A engage the lower face of the circuit board 1 to lock the attachment, bringing the contact: elements 13 into contact with the circuit traces 4 of the circuit board 1.

Then, the LCD 3 is attached to the light conductive plate 2, bringing the contact elements 13 into contact with the circuit traces 5 of the LCD 3. Consequently, signals flows from the circuit board 1 to the driving section 14 via Lhe contact elements 13 for driving the LCD 3 to display the light that is generated by the LED 6 and dispersed and transmitted by the light conductive plate 2.

The respective contact elements 13 undergo elastic compression between the circuit board 1 and the LCD 3 and electrically connect the corresponding circuit traces 4 and 5. Since the projected portions of the contact elements 13 are compressed, the contact elements undergo deformation independently of the other contact elements. Thus, even if the holder section 10, the circuit board and/or the LCD is not perfectly flat, the respective contact elements independently move and assure close contacts. Since the holder section 10 is separated from the light transparent section 7 by the elongated window 11, the holder section 10 is flexible, enhancing the follow-up characteristics of the contact elements after the circuit board 1 and the LCD 3.

Alternatively, the holder section may be made separately from but supported by the light conductive plate.

In Fig. 3, the holder section 10 is joined to the transparent section 7 with a thin web 15 to keep it flexible. A space 16 is provided between each end of the holder section 10 and the adjacent frame section 8 to improve the flexibility. The thickness of the holder section 10 is made thinner than the transparent section 7 to further improve the flexibility.

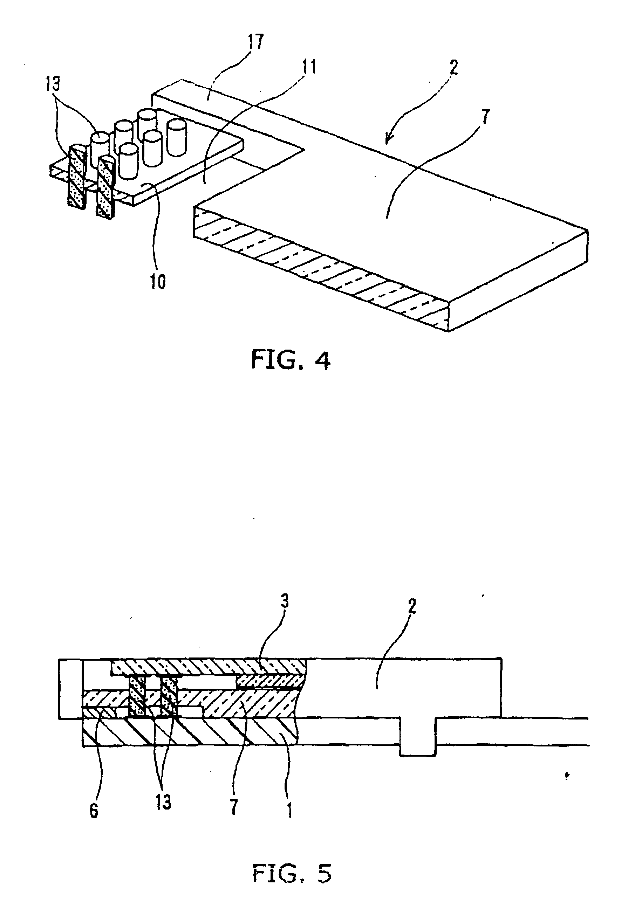

In Fig. 4, the holder section 10 is made thinner than that of Fig. 3. It is supported by arm sections 17 of the light conductive plate 2 at opposite ends thereof, forming the elongated window 11 between it and the transparent section 7.

In Fig. 5, the LED 6 is mounted on the front edge portion of the circuit board 1, and the holder section 10 is made integrally with the transparent section 7 so that the contact elements 13 are provided between the LED 6 and the transparent section 7. Consequently, light flows from the LED 6 to the transparent section 7 via spaces between the contact elements 13. As a result, the degree of design freedom for arranging the LED is increased.

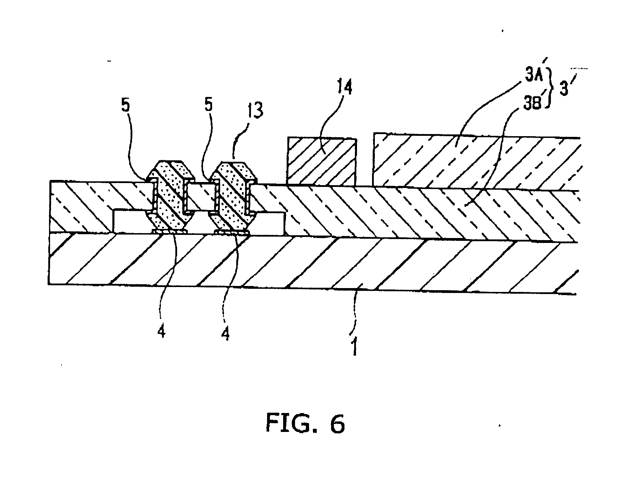

In Fig. 6, the circuit board 1 and the light emitting LCD 3' are connected without the light conductive plate. The lower panel 3B' extends forwardly more than the upper pane) 3A', and the driving section 14 and the contact elements 13 are provided on the extended section. The circuit traces 5 extend to the inside walls of apertures through which the contact elements 13 of an electrically conductive elastomer are placed so as to contact the circuit traces 5. Opposite ends of each contact element 13 are flared to secure the contact element to the lower panel 3B. The lower projection of each contact element 13 makes spring contact with a circuit trace 4 of the circuit board 1. Since no light conductive plate is used, the structure is simplified.

As has been described above, according to the invention, a plurality of contact elements are made of an electrically conductive elastomer so as to project from the holder section for making spring contact with the circuit traces of a circuit board so that the individual contact elements undergo independently elastic deformation for making follow-up after dimensional errors or warps of the circuit board and/or the LCD, thus assuring good contact. By integrating the contact elements and the light conductive plate it is possible to avoid the assembling operation and error of the separate parts, thus improving the manufacturing process and precision.

## Claims

1. An electrical connector supported by a light conductive plate provided between a circuit hoard and a liquid crystal display (LCD), comprising:
a holder section and
a plurality of contact elements that are made of an electrically conductive elastomer and supported by said holder section, with opposite ends thereof brought into spring contact with circuit trances of said circuit board and said LCD to electrically connect said circuit board and said LCD.

2. An electrical connector according to claim 1, wherein said holder section is made integrally with said light conductive plate and of the same material as that of said light conductive plate.

3. An electrical connector according to claim 1 or 2, wherein said holder section has a thickness less than that of said light conductive plate.

4. An electrical connector according to one of claims 1-3, wherein said light conductive plate has a transparent section separated from said holder section by a space.

5. An electrical connector according to claim 2, wherein said light conductive plate has a transparent section which is continuous to said holder section, said electrical connector further comprising a light emitting diode (LED) provided on said circuit board at a position opposite to said transparent section relative to said holder section.

6. An electrical connector for electrically connecting a circuit board and an LCD placed upon said circuit board, comprising a plurality of contact elements that are made of an electrically conductive clastomer and supported by said LCD such that said contact elements are in contact with corresponding circuit traces of said LCD, and have projecting portions projecting from said LCD for spring contact with said circuit board.

7. An electrical connector supported by a light conductive plate provided between a circuit board and an LCD to electrically connect said circuit board and said LCD, said electrical connector comprising:
a plurality of contact elements made of an electrically conductive material and
a holder section integrally molded with the same material as that of said light conductive plate together with said contact elements such that opposite ends of said contact elements are brought into spring contact with corresponding circuit traces of said circuit board and said LCD.

8. An electrical connector according to claim 7, wherein said light conductive plate is made of a rigid material.
